# EUROPEAN PATENT SPECIFICATION

(11) **EP 3 893 079 B1**
(45) Date of publication and mention of the grant of the patent: **27.12.2023**
(21) Application number: 20877533.8
(22) Date of filing: 10.06.2020
(51) Int. Cl.: G05F 3/26, G05F 1/56

(54) **IN-CHIP REFERENCE CURRENT GENERATION CIRCUIT**
IN-CHIP-REFERENZSTROMERZEUGUNGSSCHALTUNG
CIRCUIT DE GÉNÉRATION DE COURANT DE RÉFÉRENCE SUR PUCE

(30) Priority: 16.10.2019 CN 201910981700
(43) Date of publication of application: 13.10.2021
(73) Proprietor: Changxin Memory Technologies, Inc., Hefei City, Anhui 230000 (CN)
(72) Inventor: JI, Rumin, Hefei, Anhui 230000 (CN); YING, Zhan, Hefei, Anhui 230000 (CN)
(74) Representative: V.O.
(86) International application number: PCT/CN2020/095337
(87) International publication number: WO 2021/073126

(56) References cited:
- CN-A- 101 676 828
- CN-A- 101 859 158
- CN-A- 102 419 609
- CN-A- 107 239 092
- US-A1- 2008 048 714
- US-A1- 2016 211 031
- US-A1- 2016 231 766
- US-B1- 10 429 874

## Description

### CROSS REFERENCE

This application claims priority to Chinese Patent Application No. 201910981700.6, titled "IN-CHIP REFERENCE CURRENT GENERATION CIRCUIT" and filed on October 16, 2019.

### TECHNICAL FIELD

The present disclosure relates to the field of integrated circuit, and more particularly, to an on-chip reference current generating circuit.

### BACKGROUND

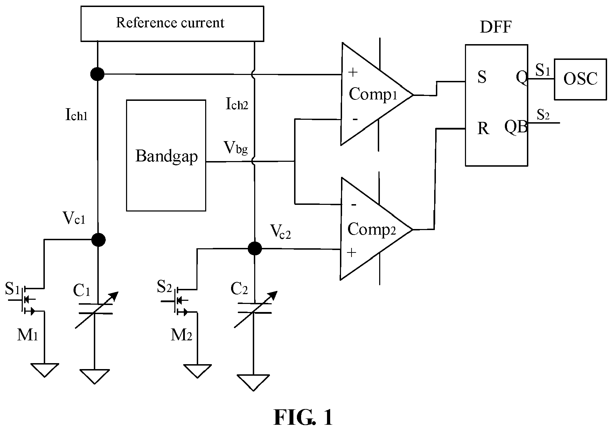

A reference current is a current insensitive to variations of factors such as temperatures, voltages, and processes. The reference current is widely used in design of integrated circuits. For example, an oscillator circuit formed by charging and discharging a capacitor with the reference current may be used in a charge pump circuit in a DRAM. FIG. 1 is an oscillator circuit diagram. Capacitors C₁ and C₂ are charged by the reference currents I_{ch1} and I_{ch2}. When voltages across the capacitors C₁ and C₂ are charged to be the same as the reference voltage V_{bg}, comparators comp₁ and comp₂ flip to set or reset a DFF. An output signal S₁ or Sz flips and discharges the corresponding capacitor, until a clock signal is generated based on cyclic actions. Factors such as process deviation and temperature variation may cause the reference current to change, and the change of the reference current may affect charging time of the capacitor, and then affect a frequency of the clock signal, resulting in insufficient accuracy of an oscillator frequency.

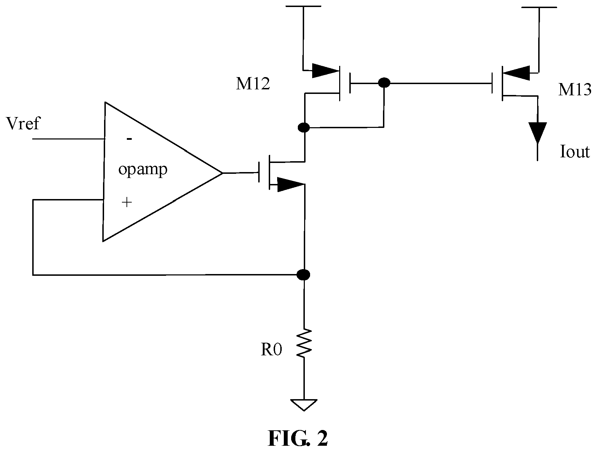

FIG. 2 illustrates a reference current generating circuit frequently used in a chip. With reference to FIG. 2, by means of a clamping action of an operational amplifier amp, the voltage across a resistor R0 is also Vref, such that the current flowing through the resistor is Vref/R0. Through a current mirror composed of a transistor M12 and a transistor M13, the generated current may be outputted to other modules for use. The Vref may be obtained by dividing an internal bandgap voltage, and generally the Vref may be trimmed to obtain a reference voltage Vref having a higher precision. The finally obtained Vref is insensitive to variations of processes, voltages, and temperatures. As an on-chip resistor, R0 generally is a polycrystalline resistor, and its resistance may vary greatly with temperature or process tolerances, which causes a consequence that the finally outputted current (i.e., the reference current) may also vary greatly with temperature or process tolerances. If the R0 is an off-chip resistor, it may occupy additional pin resources, which is disadvantageous to the miniaturization of components, and may inevitably consume a lot of space and increase production costs, and thus is not economical.

Therefore, how to enable an on-chip reference current generating circuit to output a stable reference current becomes a technology that needs to be solved urgently.

US 2016/0231766 A1 discloses a self-calibrating current source system, which includes a current source, and further comprises: a self-calibrating resistors array disposed in such a way that the self-calibrating resistors array is associated with an internal resistors array of said current source; a comparator for comparing the voltage of the self-calibrating resistors array with the voltage of the output terminal resistance of said chip; a control module for receiving the compared result from said comparator and outputting a control signal to control the self-calibrating resistors array and said internal resistors array in association with it. The self-calibrating current source system according to the invention may automatically adjust to enable the internal resistors array to be identical to the resistor of the output terminal resistance.

US 2008/0048714 A1 discloses an one-die termination including: a code generator configured to generate a calibration code in response to a voltage of a first node and a reference voltage; a calibration resistor unit connected to the first node, and configured to be turned on and off in response to the calibration code; and a reference resistor unit coupled to the calibration resistor unit, and configured to be turned on and off in response to a control signal.

US 2016/0211031 A1 discloses techniques for generating a temperature independent reference current, which may be used during calibration. The temperature independent reference current may be generated based on a current through an on-chip calibration resistor. This alleviates the need for an off chip calibration resistor, which can be costly and cause slow calibration. A voltage at one terminal of the on chip calibration resistor may be modulated to substantially cancel a temperature coefficient of the on chip calibration resistor. This may result in the current passing through the on chip calibration resistor being temperature independent. The temperature independent reference current may be based on a reference voltage and a target calibration resistance.

### SUMMARY

The invention is set out in the appended set of claims.

An advantage of the present disclosure is as below. After the first pull-down resistor unit of the on-chip reference current generating circuit is calibrated by the ZQ calibration circuit, an equivalent resistance of the first pull-down resistor unit is insensitive to variations of processes, voltages, and temperatures, such that the reference current outputted from the current mirror unit may not vary greatly with the processes, the voltages, and the temperatures. Therefore, the on-chip reference current generating circuit provided by the present disclosure can supply a stable reference current.

### BRIEF DESCRIPTION OF THE DRAWINGS

FIG. 1 is a circuit diagram of an existing oscillator;
FIG. 2 is a reference current generating circuit frequently used in an existing chip;
FIG. 3 is a circuit diagram of a first embodiment of an on-chip reference current generating circuit according to the present disclosure; and
FIG. 4 is a circuit diagram of a second embodiment of an on-chip reference current generating circuit according to the present disclosure.

### DETAILED DESCRIPTION

Embodiments of the on-chip reference current generating circuit provided by the present disclosure are described below in detail with reference to the accompanying drawings.

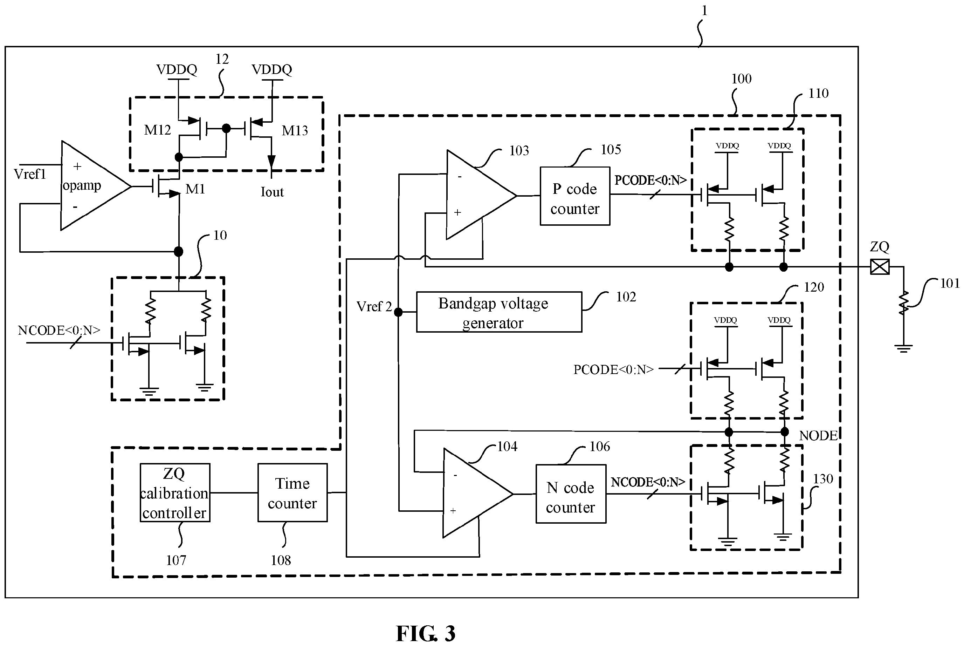

The on-chip reference current generating circuit provided by the present disclosure is arranged in a chip 1 to supply at least one reference current to at least one load. FIG. 3 is a circuit diagram of a first embodiment of the on-chip reference current generating circuit according to the present disclosure. With reference to FIG. 3, the on-chip reference current generating circuit includes a transistor M1, an operational amplifier unit opamp, a current mirror unit 12, and a first pull-down resistor unit 10. In this embodiment, the transistor M1 is an N-type transistor.

A reference voltage Vrefl is inputted to a positive input terminal of the operational amplifier unit opamp, a negative input terminal of the operational amplifier unit opamp is coupled to a source of the transistor M1, and an output terminal of the operational amplifier unit opamp is coupled to a gate of the transistor M1. In the embodiment, the reference voltage is generated by a bandgap voltage generator 102. The bandgap voltage generator 102 is coupled to the positive input terminal of the operational amplifier unit opamp, and is configured to transmit the generated reference voltage to the positive input terminal of the operational amplifier unit opamp.

The current mirror unit 12 is coupled between a drain of the transistor M1 and a power supply voltage and is configured to output a current generated by the on-chip reference current generating circuit to the load for use. In this embodiment, the current mirror unit 12 is composed of a P-type transistor M12 and a P-type transistor M13. The P-type transistor M12 has a source connected to a power supply potential, and a gate and a drain connected to the drain of the transistor M1. The P-type transistor M13 has a source connected to the power supply potential, and a gate connected to a gate and a drain of the P-type transistor M12. A drain of the P-type transistor M13 outputs a reference current. In other embodiments of the present disclosure, circuits in other forms may also be used as the current mirror unit. The current mirror unit 12 can implement replication or multiplication of a current signal. Specifically, in this embodiment, the current mirror unit 12 replicates a current flowing through the first pull-down resistor unit 10, and outputs the current as the reference current.

With an equivalent resistance of R0, the first pull-down resistor unit 10 is coupled between the source of the transistor M1 and a ground. By means of a clamping action of the operational amplifier unit 11, the on-chip reference current generating circuit ensures that a voltage, whose magnitude is also Vrefl, across the first pull-down resistor unit 10 is equal to the reference voltage Vrefl. In this case, the current flowing through the first pull-down resistor unit 10 is Vref1/R0. The current mirror unit 12 composed of the P-type transistor M12 and the P-type transistor M13 outputs the generated current as the reference current to other modules for use.

As described in the background art, if the first pull-down resistor unit 10 is a resistor, its resistance may vary greatly with temperature or process tolerances, which causes a consequence that the finally outputted reference current may also vary greatly with temperature or process tolerances. Therefore, in order to overcome the above technical problem, in an embodiment of the present disclosure, the first pull-down resistor unit 10 is not a polycrystalline resistor, but is a resistor unit calibrated by a ZQ calibration circuit 100. The first pull-down resistor unit 10 includes a plurality of transistors coupled in parallel.

A memory chip such as DDR4 generally has a ZQ calibration function. A pull-up unit and a pull-down unit are calibrated by the ZQ calibration circuit, such that equivalent resistance of the pull-up unit and the pull-down unit meet accuracy requirements. That is, the equivalent resistances of the pull-up unit and the pull-down unit calibrated are insensitive to variations of processes, voltages, and temperatures.

Specifically, with reference to FIG. 3, the ZQ calibration circuit 100 includes a first pull-up resistor unit 110, a second pull-up resistor unit 120, a second pull-down resistor unit 130, a reference voltage generator 102, a first comparator 103, a second comparator 104, a P code counter 105, and an N code counter 106. The ZQ calibration includes a pull-up calibration and a pull-down calibration.

A method for the pull-up calibration is as below. A power supply voltage VDDQ is divided by the first pull-up resistor unit 110 and a reference resistor 101 to supply a voltage to a node ZQ. The reference resistor 101 connected to a pin coupled to the node ZQ generally has a resistance of 24052. The first comparator 103 compares the voltage at the node ZQ with a reference voltage Vref2 outputted from the bandgap voltage generator 102, to generate an up/down signal UP/DN. The reference voltage Vre2f generally is set to be a half of the supplied voltage, i.e., VDDQ/2. The P code counter 105 receives the up/down signal UP/DN, to generate a binary code PCODE<0:N> as the pull-up calibration code. The binary code PCODE<0:N> enables/disables MOS transistors coupled in parallel in the first pull-up resistor unit 110 to calibrate the resistance of the first pull-up resistor unit 110. The calibrated resistance of the first pull-up resistor unit 110 has an effect on the voltage at the node ZQ. The above operation is repeated. That is, the pull-up calibration is performed on the first pull-up resistor unit 110, such that the resistance of the first pull-up resistor unit 110 becomes equal to the resistance of the reference resistor 101. The binary code PCODE<0:N> generated during the pull-up calibration is also inputted to the second pull-up resistor unit 120, and the resistance of the second pull-up resistor unit 120 is determined.

Similar to performing the pull-up calibration, the pull-down calibration is performed. A binary code NCODE<0:N> generated by the second comparator 104 and the N code counter 106 is used as a pull-down calibration code. By using the pull-down calibration code, the voltage at the node NODE becomes equal to the reference voltage Vref2. The pull-down calibration is performed, such that the resistance of the second pull-down resistor unit 130 becomes equal to the resistance of the second pull-up resistor unit 120.

The binary codes PCODE<0:N> and NCODE<0:N> generated by the ZQ calibration are inputted to an input/output circuit to calibrate each resistor of the resistor units. In the case of a semiconductor memory device, it is determined that the binary codes PCODE<0:N> and NCODE<0:N> are connected to the resistances of the pull-up and pull-down resistors of a DQ pad. The pull-up and pull-down resistors have layouts similar to those of the above pull-up and pull-down resistor units. Further, a ZQ calibration controller 107 and a time counter 108 are employed to control the ZQ calibration.

After the first pull-up resistor unit 110 and the second pull-down resistor unit 130 are calibrated by the ZQ calibration circuit 100, their equivalent resistances meet the accuracy requirements. That is, the equivalent resistances of the calibrated first pull-up resistor unit 110 and the calibrated second pull-down resistor unit 130 are insensitive to variations of processes, voltages and temperatures.

In view of the above advantages of the ZQ calibration circuit, the on-chip reference current generating circuit provided by the present disclosure uses the pull-down calibration code NCODE<0:N> of the ZQ calibration circuit, and duplicates the second pull-down resistor unit 130 of the ZQ calibration circuit as the first pull-down resistor unit 10 of the on-chip reference current generating circuit provided by the present disclosure. In this case, the first pull-down resistor unit 10 is determined as a resistor unit calibrated by the ZQ calibration circuit, and the equivalent resistance of the first pull-down resistor unit 10 is insensitive to variations of processes, voltages and temperatures. In this embodiment, the first pull-down resistor unit 10 and the second pull-down resistor unit 130 are strictly matched in layout, placement and routing. MOS transistors corresponding to the first pull-down resistor unit 10 and the second pull-down resistor unit 130 adopt the same size and arrangement direction. Furthermore, the first pull-down resistor unit 10 and the second pull-down resistor unit 130 adopt the same control signal, i.e., the pull-down calibration code NCODE<0:N>.

Preferably, in the layout and placement, the first pull-down resistor unit 10 is arranged adjacent to the second pull-down resistor unit 130 to prevent other influence factors from causing different calibrations on the first pull-down resistor unit 10 and the second pull-down resistor unit 130 by the ZQ calibration circuit, thereby reducing the sensitivity of the equivalent resistance of the first pull-down resistor unit 10 to the variations of processes, voltages and temperatures.

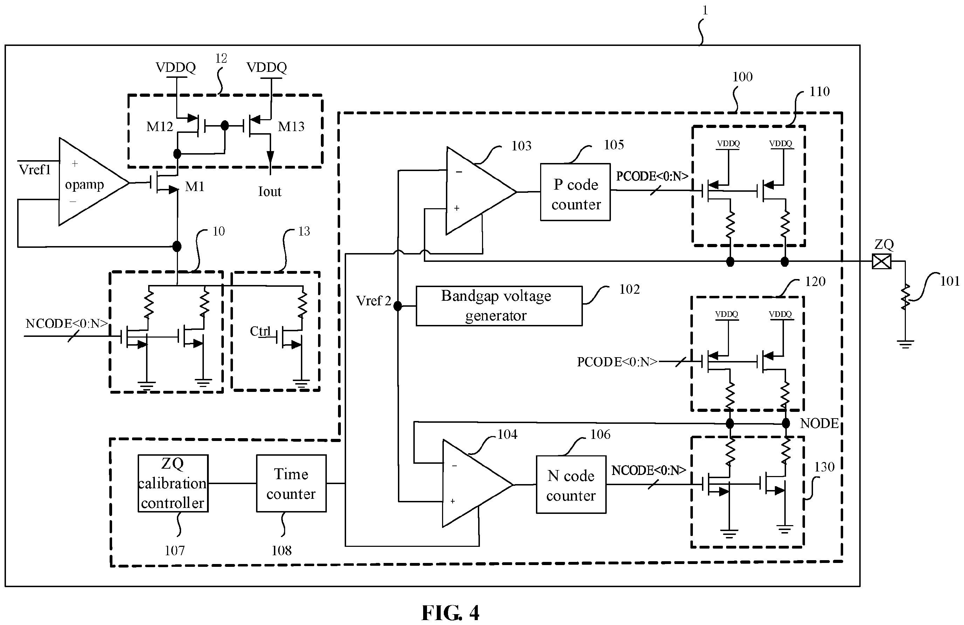

Further, to ensure the first pull-down resistor unit 10 to be closer to a real resistance, the value of the reference voltage Vrefl of the on-chip reference current generating circuit provided by the present disclosure is not allowed to be too large. In both embodiments of figures 3 and 4 the value of the reference voltage Vrefl of the on-chip reference current generating circuit provided by the present disclosure is less than 2(V_{GS}-V_{TH}), such that the MOS transistor in the first pull-down resistor unit 10 is in a triode region, where V_{GS} represents a gate-source voltage of the MOS transistor in the first pull-down resistor unit 10, and V_{TH} represents a breakdown voltage of the MOS transistor in the first pull-down resistor unit 10. The value of the reference voltage Vrefl is much smaller than 2(V_{GS}-V_{TH}). The value of the reference voltage Vrefl is 1/100~1/10 of 2(V_{GS}-V_{TH}), such that the MOS transistor in the first pull-down resistor unit 10 is in a deep triode region, and the first pull-down resistor unit 10 is closer to the real resistance.

In the on-chip reference current generating circuit provided by the present disclosure, a traditional on-chip resistor is replaced with the first pull-down resistor unit 10 calibrated by the ZQ calibration circuit. The equivalent resistance of the first pull-down resistor unit 10 calibrated by the ZQ calibration circuit may not vary greatly with temperature or process tolerances, and the reference current outputted from the current mirror unit 12 may not vary greatly with the temperature or process tolerances. Therefore, the on-chip reference current generating circuit provided by the present disclosure can supply a stable reference current.

In addition, it is found that when the ZQ calibration circuit is initialized, the first pull-down resistor unit 10 is completely disabled, and thus no current can be generated, which may have an influence on the generation of the reference current. To prevent the occurrence of the above problem, the present disclosure also provides a second embodiment of the on-chip reference current generating circuit. FIG. 4 is a circuit diagram of the on-chip reference current generating circuit according to the second embodiment of the present disclosure. With reference to FIG. 4, to prevent the influence on the generation of the reference current caused by failed generation of the current due to that the first pull-down resistor unit 10 is completely disabled when the ZQ calibration circuit is initialized, the on-chip reference current generating circuit further includes a bypass resistor unit 13 connected in parallel with the first pull-down resistor unit 10. The bypass resistor unit 13 is enabled before the first pull-down resistor unit 10 is calibrated by the ZQ calibration circuit 100, to ensure that there is still a current path. The bypass resistor unit 13 is disabled after the first pull-down resistor unit 10 is calibrated by the ZQ calibration circuit 100, which has no influence on the normal operation of the reference current generating circuit.

In this embodiment, the bypass resistor unit 13 includes at least one transistor. In this embodiment, the transistor is an NMOS transistor. The source of the transistor is grounded, and a control signal Ctrl is inputted to the gate of the transistor. When the transistor of the first pull-down resistor unit 10 is not enabled, the control signal Ctrl is high, the transistor is enabled, and the bypass resistor unit 13 is grounded, to ensure that there is still a current path in the on-chip reference current generating circuit. The bypass resistor unit 13 is disabled after the ZQ calibration function works, which has no influence on the normal operation of the reference current generating circuit. The control signal Ctrl may be generated by a controller of an integrated circuit.

The above descriptions are merely the preferred embodiments of the present invention. It should be noted that those of ordinary skill in the art may make several improvements and modifications without departing from the scope of the claims.

## Claims

1. An on-chip reference current generating circuit for supplying at least one reference current to at least one load, the on-chip reference current generating circuit comprising:
a transistor (M1);
an operational amplifier unit, a reference voltage being inputted to a positive input terminal of the operational amplifier unit, a negative input terminal of the operational amplifier unit being coupled to a source of the transistor (M1), and an output terminal of the operational amplifier unit being coupled to a gate of the transistor (M1);
a first pull-down resistor unit (10) coupled between the source of the transistor (M1) and a ground, the first pull-down resistor unit (10) being a resistor unit calibrated by a ZQ calibration circuit (100) and including a plurality of MOS transistors in parallel; and
a current mirror unit (12) coupled between a drain of the transistor (M1) and a power supply voltage, wherein the current mirror unit (12) is configured to replicate the current flowing through the pull-down resistor unit (10) and provide an output current (Iout) to the load for use,
wherein the reference voltage is 1/100~1/10 of 2(V_{GS}-V_{TH}), V_{GS} represents a gate-source voltage of a MOS transistor in the first pull-down resistor unit, and V_{TH} represents a breakdown voltage of the MOS transistor in the first pull-down resistor unit.

2. The on-chip reference current generating circuit of claim 1, further comprising a bypass resistor unit (13) connected in parallel with the first pull-down resistor unit (10).

3. The on-chip reference current generating circuit of claim 2, wherein the bypass resistor unit (13) is enabled before the first pull-down resistor unit (10) is calibrated by the ZQ calibration circuit (100), and the bypass resistor unit (13) is disabled after the first pull-down resistor unit (10) is calibrated by the ZQ calibration circuit (100).

4. The on-chip reference current generating circuit of claim 3, wherein the bypass resistor unit (13) comprises at least one transistor.

5. The on-chip reference current generating circuit of claim 4, wherein the source of the at least one transistor in the bypass resistor unit (13) is grounded.

6. The on-chip reference current generating circuit of claim 1, further comprising a bandgap voltage generator (102), wherein the bandgap voltage generator (102) is coupled to a positive input terminal of the operational amplifier unit and is configured to generate the reference voltage.

7. The on-chip reference current generating circuit of claim 1, wherein the transistor is an N-type transistor.

8. The on-chip reference current generating circuit of claim 4 or 5, wherein the at least one transistor is an N-Metal-Oxide-Semiconductor , NMOS, transistor.

9. The on-chip reference current generating circuit of claim 4 or 5, wherein a control signal is input to a gate of the at least one transistor.

10. The on-chip reference current generating circuit of claim 9, wherein the control signal is generated by a controller of an integrated circuit.

11. A system comprising the on-chip reference current generating circuit of claim 1 and a ZQ calibration circuit, wherein the ZQ calibration circuit has a second pull-down resistor unit (130) and a second pull-down calibration code configured for calibrating the second pull-down resistor unit (130), wherein
the first pull-down resistor unit (10) is configured to duplicate the second pull-down resistor unit (130), and use the second pull-down calibration code as a first pull-down calibration code of the first pull-down resistor unit (10).

12. The system of claim 11, wherein the first pull-down resistor unit (10) is arranged adjacent to the second pull-down resistor unit (130).

## Patentansprüche

1. On-Chip-Referenzstrom-Erzeugungsschaltung zum Bereitstellen mindestens eines Referenzstroms an mindestens eine Last, wobei die On-Chip-Referenzstrom-Erzeugungsschaltung umfasst:
einen Transistor (M1);
eine Operationsverstärkereinheit, wobei eine Referenzspannung in einen positiven Eingangsanschluss der Operationsverstärkereinheit eingegeben wird, ein negativer Eingangsanschluss der Operationsverstärkereinheit mit einer Source des Transistors (M1) gekoppelt ist, und ein Ausgangsanschluss der Operationsverstärkereinheit mit einem Gate des Transistors (M1) gekoppelt ist;
eine erste Pull-Down-Widerstandseinheit (10), die zwischen der Source des Transistors (M1) und einer Masse gekoppelt ist, wobei die erste Pull-Down-Widerstandseinheit (10) eine Widerstandseinheit ist, die durch eine ZQ-Kalibrierungsschaltung (100) kalibriert ist und eine Vielzahl von MOS-Transistoren parallel enthält; und
eine Stromspiegeleinheit (12), die zwischen einem Drain des Transistors (M1) und einr Stromversorgungsspannung gekoppelt ist, wobei die Stromspiegeleinheit (12) so ausgelegt ist, dass sie den durch die Pull-Down-Widerstandseinheit (10) fließenden Strom repliziert und einen Ausgangsstrom (Iout) zur Verwendung an die Last bereitstellt,
wobei die Referenzspannung 1/100~1/10 von 2(V_{GS}-V_{TH}) beträgt, V_{GS} eine Gate-Source-Spannung eines MOS-Transistors in der ersten Pull-Down-Widerstandseinheit darstellt und V_{TH} eine Durchbruchspannung des MOS-Transistors in der ersten Pull-Down-Widerstandseinheit darstellt.

2. On-Chip-Referenzstrom-Erzeugungsschaltung nach Anspruch 1, die ferner eine Bypass-Widerstandseinheit (13) umfasst, die parallel zu der ersten Pull-Down-Widerstandseinheit (10) geschaltet ist.

3. On-Chip-Referenzstrom-Erzeugungsschaltung nach Anspruch 2, wobei die Bypass-Widerstandseinheit (13) aktiviert wird, bevor die erste Pull-Down-Widerstandseinheit (10) durch die ZQ-Kalibrierungsschaltung (100) kalibriert wird, und die Bypass-Widerstandseinheit (13) deaktiviert wird, nachdem die erste Pull-Down-Widerstandseinheit (10) durch die die ZQ-Kalibrierungsschaltung (100) kalibriert wurde.

4. On-Chip-Referenzstrom-Erzeugungsschaltung nach Anspruch 3, wobei die Bypass-Widerstandseinheit (13) mindestens einen Transistor umfasst.

5. On-Chip-Referenzstrom-Erzeugungsschaltung nach Anspruch 4, wobei die Source des mindestens einen Transistors in der Bypass-Widerstandseinheit (13) geerdet ist.

6. On-Chip-Referenzstrom-Erzeugungsschaltung nach Anspruch 1, die ferner einen Bandlückenspannungsgenerator (102) umfasst, wobei der Bandlückenspannungsgenerator (102) mit einem positiven Eingangsanschluss der Operationsverstärkereinheit gekoppelt ist und so ausgelegt ist, dass er die Referenzspannung erzeugt.

7. On-Chip-Referenzstrom-Erzeugungsschaltung nach Anspruch 1, wobei der Transistor ein N-Typ-Transistor ist.

8. On-Chip-Referenzstrom-Erzeugungsschaltung nach Anspruch 4 oder 5, wobei der mindestens eine Transistor ein N-Metall-Oxid-Halbleiter (NMOS)-Transistor ist.

9. On-Chip-Referenzstrom-Erzeugungsschaltung nach Anspruch 4 oder 5, wobei ein Steuersignal in ein Gate des mindestens einen Transistors eingegeben wird.

10. On-Chip-Referenzstrom-Erzeugungsschaltung nach Anspruch 9, wobei das Steuersignal von einem Controller einer integrierten Schaltung erzeugt wird.

11. System mit der On-Chip-Referenzstrom-Erzeugungsschaltung nach Anspruch 1 und einer ZQ-Kalibrierungsschaltung, wobei die ZQ-Kalibrierungsschaltung eine zweite Pull-Down-Widerstandseinheit (130) und einen zweiten Pull-Down-Kalibrierungscode aufweist, der zum Kalibrieren der zweiten Pull-Down-Widerstandseinheit (130) ausgelegt ist, wobei
die erste Pull-Down-Widerstandseinheit (10) so ausgelegt ist, dass sie die zweite Pull-Down-Widerstandseinheit (130) dupliziert und den zweiten Pull-Down-Kalibrierungscode als einen ersten Pull-Down-Kalibrierungscode der ersten Pull-Down-Widerstandseinheit (10) verwendet.

12. System nach Anspruch 11, wobei die erste Pull-Down-Widerstandseinheit (10) neben der zweiten Pull-Down-Widerstandseinheit (130) angeordnet ist.

## Revendications

1. Circuit de génération de courant de référence sur puce destiné à fournir au moins un courant de référence à au moins une charge, le circuit de génération de courant de référence sur puce comprenant :
un transistor (M1) ;
une unité d'amplificateur opérationnel, dans laquelle une tension de référence est appliquée en entrée à une borne d'entrée positive de l'unité d'amplificateur opérationnel, une borne d'entrée négative de l'unité d'amplificateur opérationnel est couplée à une source du transistor (M1), et une borne de sortie de l'unité d'amplificateur opérationnel est couplée à une grille du transistor (M1) ;
une première unité de résistance de rappel vers le niveau bas (10) couplée entre la source du transistor (M1) et une masse, la première unité de résistance de rappel vers le niveau bas (10) étant une unité de résistance étalonnée par un circuit d'étalonnage ZQ (100) et incluant une pluralité de transistors MOS en parallèle ; et
une unité de miroir de courant (12) couplée entre un drain du transistor (M1) et une tension d'alimentation électrique, dans laquelle l'unité de miroir de courant (12) est configurée de manière à reproduire le courant circulant à travers l'unité de résistance de rappel vers le niveau bas (10) et fournir un courant de sortie (lout) à la charge, à des fins d'utilisation ;
dans lequel la tension de référence est égale à 1/100_{~}1/10 de 2(V_{GS}-V_{TH}), « V_{GS} » représente une tension de source-grille d'un transistor MOS dans la première unité de résistance de rappel vers le niveau bas, et « V_{TH} » représente une tension de claquage du transistor MOS dans la première unité de résistance de rappel vers le niveau bas.

2. Circuit de génération de courant de référence sur puce selon la revendication 1, comprenant en outre une unité de résistance de dérivation (13) connectée en parallèle à la première unité de résistance de rappel vers le niveau bas (10).

3. Circuit de génération de courant de référence sur puce selon la revendication 2, dans lequel l'unité de résistance de dérivation (13) est activée avant que la première unité de résistance de rappel vers le niveau bas (10) ne soit étalonnée par le circuit d'étalonnage ZQ (100), et l'unité de résistance de dérivation (13) est désactivée après que la première unité de résistance de rappel vers le niveau bas (10) a été étalonnée par le circuit d'étalonnage ZQ (100).

4. Circuit de génération de courant de référence sur puce selon la revendication 3, dans lequel l'unité de résistance de dérivation (13) comprend au moins un transistor.

5. Circuit de génération de courant de référence sur puce selon la revendication 4, dans lequel la source dudit au moins un transistor dans l'unité de résistance de dérivation (13) est mise à la terre.

6. Circuit de génération de courant de référence sur puce selon la revendication 1, comprenant en outre un générateur de tension de bande interdite (102), dans lequel le générateur de tension de bande interdite (102) est couplé à une borne d'entrée positive de l'unité d'amplificateur opérationnel et est configuré de manière à générer la tension de référence.

7. Circuit de génération de courant de référence sur puce selon la revendication 1, dans lequel le transistor est un transistor de type N.

8. Circuit de génération de courant de référence sur puce selon la revendication 4 ou 5, dans lequel ledit au moins un transistor est un transistor à semi-conducteur à oxyde de métal à canal N, NMOS.

9. Circuit de génération de courant de référence sur puce selon la revendication 4 ou 5, dans lequel un signal de commande est envoyé à une grille dudit au moins un transistor.

10. Circuit de génération de courant de référence sur puce selon la revendication 9, dans lequel le signal de commande est généré par un contrôleur d'un circuit intégré.

11. Système comprenant le circuit de génération de courant de référence sur puce selon la revendication 1 et un circuit d'étalonnage ZQ, dans lequel le circuit d'étalonnage ZQ présente une deuxième unité de résistance de rappel vers le niveau bas (130) et un deuxième code d'étalonnage de rappel vers le niveau bas configuré de manière à étalonner la deuxième unité de résistance de rappel vers le niveau bas (130), dans lequel
la première unité de résistance de rappel vers le niveau bas (10) est configurée de manière à reproduire la deuxième unité de résistance de rappel vers le niveau bas (130) et à utiliser le deuxième code d'étalonnage de rappel vers le niveau bas en tant qu'un premier code d'étalonnage de rappel vers le niveau bas de la première unité de résistance de rappel vers le niveau bas (10).

12. Système selon la revendication 11, dans lequel la première unité de résistance de rappel vers le niveau bas (10) est agencée de manière adjacente à la deuxième unité de résistance de rappel vers le niveau bas (130).
